(19) Europäisches Patentamt

European Patent Office

Office européen des brevets

(11) **EP 0 643 542 B1**

(12) **EUROPÄISCHE PATENTSCHRIFT**

(45) Veröffentlichungstag und Bekanntmachung des Hinweises auf die Patenterteilung:
**03.02.1999 Patentblatt 1999/05**

(51) Int Cl.6: **H04B 7/04**, H03M 13/00, H04L 1/02

(21) Anmeldenummer: **94113649.1**

(22) Anmeldetag: **31.08.1994**

(54) **Verfahren zur Vereinigung von Datenströmen**

Method for combining datastreams

Méthode pour combiner les flux des données

(84) Benannte Vertragsstaaten:
**DE SE**

(30) Priorität: **13.09.1993 DE 4331040**

(43) Veröffentlichungstag der Anmeldung:
**15.03.1995 Patentblatt 1995/11**

(73) Patentinhaber: **SIEMENS AKTIENGESELLSCHAFT**
**80333 München (DE)**

(72) Erfinder: **Eul, Hermann-Josef**
**D-85764 Oberschleissheim (DE)**

(56) Entgegenhaltungen:
EP-A- 0 392 603     EP-A- 0 460 748
EP-A- 0 594 354     DE-A- 2 630 084
DE-A- 3 423 289     US-A- 4 718 081

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Verfahren zur Vereinigung von Datenströmen bei Uplink Macro-Diversity in einem zellularen Mobilfunknetz.

Im zellularen Mobilfunk wird flächendeckende Versorgung in der Regel dadurch erreicht, daß Basisstationen räumlich so angeordnet werden, daß sich ihr Versorgungsbereich ergänzt, siehe z.B. US-Patent US-A-4 718 081. Bewegt sich ein Teilnehmer aus dem Bereich seiner Basisstation heraus, wird er an der Zellgrenze durch einen Handover an die das angrenzende Gebiet versorgende Basisstation weitergereicht. In der Realität sind diese Zellgrenzen nicht scharf ausgeprägt, sondern weisen je nach topographischen Bedingungen mehr oder minder diffusen Charakter auf. Damit der Teilnehmer sicher zur Nachbarstation weitergeleitet werden kann und um ein mehrfaches Vor- und Zurückreichen zu vermeiden, werden die Zellen mit einer deutlichen Überlappung geplant. Dies führt zu höheren Infrastrukturkosten und damit zu einer verminderten Rentabilität des Mobilfunknetzes.

Zur Vermeidung dieses Nachteils ist für künftige Netze ein sogenannter Softhandover, auch Macro-Diversity genannt vorgeschlagen. Hierbei wird die Verbindung zur Mobilstation von zwei oder mehreren Basisstationen aufrechterhalten, wenn sich diese in einem Zellgrenzbereich befindet. Die Signale der beteiligten Basisstationen werden einem gemeinsamen Punkt zugeführt. Dem Signal wird blockweise ein Gütemaß, beispielsweise die mittlere Empfangsfeldstärke während des Empfangs dieses Sprachblockes zugeordnet. Von den am Vereinigungspunkt ankommenden Sprachblöcken wird stets jener weitergereicht, der das bessere Gütemaß besitzt.

Der Erfindung liegt die Aufgabe zugrunde, eine Lösung anzugeben für ein sicheres Handover eines sich innerhalb der Funkzelle eines zellularen Mobilfunknetzes bewegenden mobilen Funkteilnehmers.

Diese Aufgabe wird gemäß der Erfindung in der Weise gelöst, daß das von einer Mobilstation gesendete Signal von mehreren in Reichweite befindlichen Basisstationen gleichzeitig empfangen wird und von diesen die empfangenen Datenblöcke zu einer an einem Vereinigungspunkt liegenden Einheit gesendet werden derart, daß jedem einzelnen Bit eines Datenblocks eine in der Basisstation vorliegende Zuverlässigkeitsinformation (Softdecision-Information) zugefügt ist und daß in der Vereinigungseinheit eine bitweise Entscheidung über die Weiterleitung der Datenströme erfolgt, deren Zusammenführung mit einem geeigneten Vereinigungsverfahren realisiert ist.

Vorteilhafte Ausgestaltungen und Weiterbildungen des Erfindungsgegenstandes sind in den Unteransprüchen angegeben.

Nachstehend wird die Erfindung von anhand in der Zeichnung dargestellten Ausführungsbeispielen näher erläutert.

Es zeigen:

Figur 1     den Signalweg in einer Skizze,
Figur 2     die Prinzipdarstellung eines Datenblöcke,
Figur 3     eine Vereinigungseinheit für die Datenblöcke verschiedener Signalwege,
Figur 4     die Prinzipdarstellung eines Datenblocks mit beigefügter Zuverlässigkeitsinformation und
Figur 5     eine Vereinigungseinheit für die Datenströme.

Das erfindungsgemäße Verfahren macht sich die Tatsache zunutze, daß moderne Signalverarbeitungsalgorithmen meist zu jedem Bit eine Güteinformation liefern. Diese sogenannten Softdecision-Verfahren liefern ein Gütemaß, das an Aussagekraft weit über das der Empfangsfeldstärke hinausgeht. Die vorgeschlagene Verbesserung beruht auf drei sich ergänzenden Maßnahmen: die in der Basisstation vorhandene Softdecision-Information wird an den Vereinigungspunkt weitergeleitet; dort wird bitweise und nicht blockweise über die Weiterleitung entschieden; die Zusammenführung der ankommenden Datenströme wird mit einem geeigneten Vereinigungsverfahren (z.B. erneuter Softdecision-) anstelle des Auswahlverfahrens realisiert.

Das hier beschriebene Verfahren betrifft ausschließlich den Uplink der Verbindung. Das ist insofern kein Nachteil, da der Uplink meist der problematischere Teil einer Mobilfunkverbindung ist. Macro-Diversity ist auch im Downlink möglich, jedoch dort prinzipiell anders realisierbar.

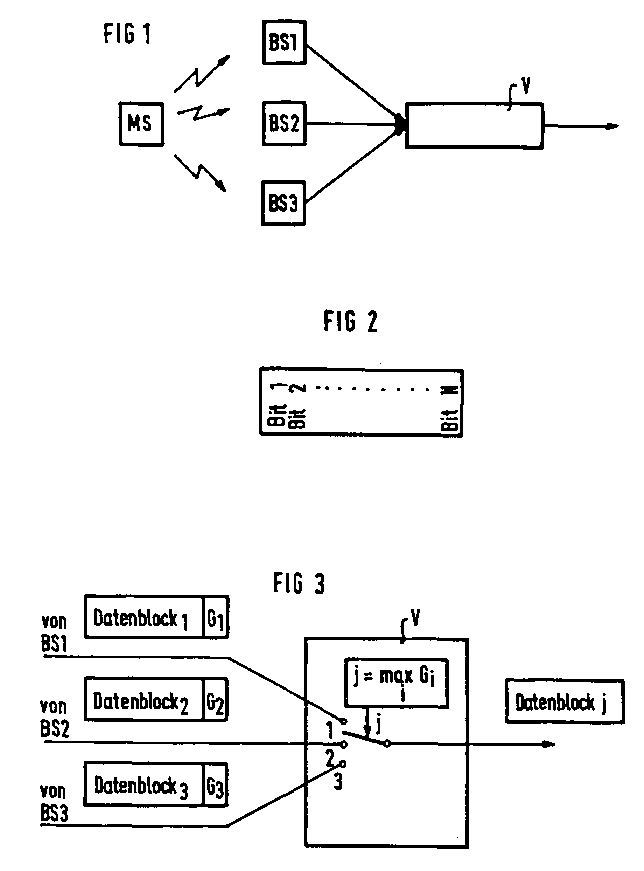

Der Signalweg für das hier Beschriebene ist in Figur 1 skizziert. Das von einer Mobilstation MS gesendete Signal wird von den in Reichweite befindlichen Basisstationen z.B. BS1, BS2, BS3 gleichzeitig empfangen. Die Zahl der Basisstationen ist grundsätzlich nicht beschränkt, in der Regel werden es je nach Überlagerungsbereich zwei oder drei Stationen sein. Die beteiligten Basisstationen senden die empfangenen Datenblöcke zu einem Vereinigungspunkt, an dem eine Vereinigungseinheit V angeordnet ist.

Bei einem konventionellen Verfahren für Sprachverbindungen werden Sprachblöcke mit einer Güteinformation, z.B. über den Empfangspegel, versehen und an den Vereinigungspunkt gesendet. In Figur 2 ist das Prinzip eines solchen Datenblocks gezeigt, der aus Bit 1, Bit 2, ... Bit N besteht. Die Vereinigungseinheit V leitet den Datenblock mit dem jeweils besten Gütewert weiter. Hierzu ist in Figur 3 der Signalweg dargestellt, bei dem der jeweils gleiche Datenblock 1, 2 und 3 eines von der Mobilstation gesendeten Signals von den Basisstationen BS1, BS2 und BS3 empfangen und an die Vereinigungseinheit V gegeben werden. Jedem Datenblock ist ein Gütewert $G_1$, $G_2$, $G_3$ beigefügt. Die Vereinigungseinheit leitet den Sprachrahmen mit dem jeweils besten Gütewert weiter. Hierfür ist in der Vereinigungseinheit V eine Einheit vorgesehen, in der die Auswahl nach dem besten Gütewert ($j = maxG_i$) ausgewählt und dementsprechend ein Umschalter angesteuert wird, wodurch der ausgewählte Datenblock j auf den weiteren Übertragungsweg gegeben wird.

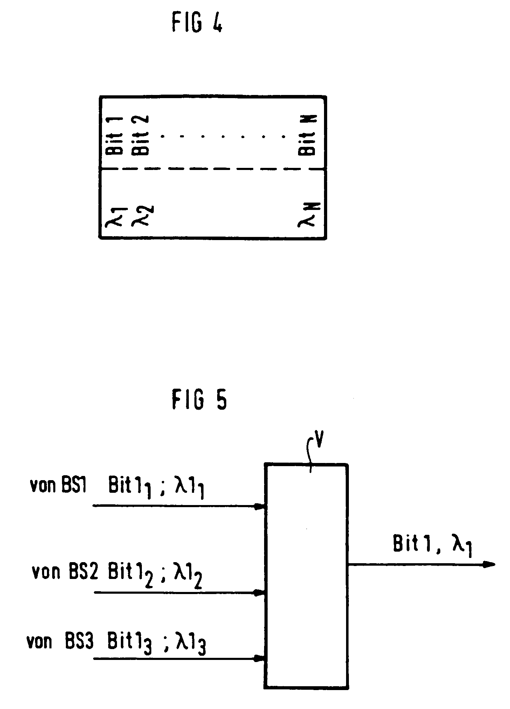

Beim erfindungsgemäßen Verfahren wird außer den in Figur 2 gezeigten Bits zu jedem einzelnen Bit noch eine Zuverlässigkeitsinformation $\lambda$, eine sogenannte Softdecision-Information gesendet (vgl. Figur 4). Eine solche Information wird von modernen Signalverarbeitungsagorithmen bereitgestellt und liegt in der Basisstation vor. Sie gibt Aufschluß über die Zuverlässigkeit, mit der dieses Bit im Detektionsprozeß erkannt wurde und geht in ihrer Aussagekraft weit über die Empfangsfeldstärke hinaus. Beispielsweise kann der Empfang trotz guter Feldstärke qualitativ schlecht sein, wenn die Verbindung durch Interferenzsignale gestört wird. Außerdem unterliegt die Mobilfunkverbindung schnellen Schwankungen (Fading), so daß auch trotz im Mittel ausreichender Feldstärke kürzere Sequenzen von Bits stark beeinträchtigt sein können.

Figur 5 zeigt in einer prinzipiellen Darstellung drei Signalwege von den Basisstationen BS1, BS2 und BS3, die in der Vereinigungseinheit V zusammengeführt werden. Nach Auswertung bzw. Ermittlung der jeweiligen Bits eines Datenblocks der drei Signalwege erfolgt in einem Vereinigungsverfahren, beispielsweise einem Softdecision-Prozeß, die bitweise Zusammenfügung des Datenblocks. Dadurch wird aus jedem Block die maximale Information in den Vereinigungsprozeß eingebracht. In Figur 5 ist in einer Einzeldarstellung das jeweils erste Bit$1_1$, $1_2$, $1_3$ mit dem zugehörigen Gütewert $\lambda 1_1$, $\lambda 1_2$, $\lambda 1_3$ dargestellt.

In der Darstellung von Bits und Softdecision-Information bestehen recht weite Freiheitsgrade. Zur Erläuterung der prinzipiellen Arbeitsweise sei folgende Annahme über die Darstellungsform gemacht:
Der Wert des Bits kann +1 oder -1 sein, wobei Bit = 1 den logischen Wert "Eins" und Bit = -1 den logischen Wert "Null" repräsentiert. Der Softdecision-Wert $\lambda$ kann im Intervall [0.0 .. 1.0] liegen. Der Wert $\lambda=0.0$ kennzeichnet absolut unzuverlässige Bits. Entsprechend charakterisiert der Wert $\lambda=1.0$ sehr zuverlässig erkannte Bits.

Basierend auf dieser Definition von Bit und Softdecision-Wert ist der Vereinigungsvorgang mit den Gleichungen

$$\texttt{Bit1} = \texttt{sign} \sum_{i} \lambda 1_i \cdot \texttt{Bit1}_i$$

und

$$\lambda 1 = \texttt{abs} \sum_{i} \lambda 1_i \cdot \texttt{Bit1}_i$$

zu beschreiben. Hierbei extrahiert die Signum-Funktion das Vorzeichen und damit den Bit-Wert, der Absolutwert der zweiten Gleichung die Qualität. Am Ausgang der Vereinigungseinheit V in Figur 5 erscheint Bit1, $\lambda 1$, das die erste Position des Datenblocks der vereinigten Datenströme bildet. Die nachfolgenden Bits werden gleichermaßen behandelt.

Die Verbesserung des erfindungsgemäßen Verfahrens basiert auf den drei Maßnahmen:

1. Die in der Basisstation vorliegende Softdecision-Information wird an den Verbindungspunkt weitergeleitet (vgl. Figur 4).

2. Die Entscheidung über die Weiterleitung der Datenströme geschieht bitweise (vgl. Figur 5). Dadurch kann aus jedem Datenblock die beste Information genutzt werden.

3. Eine weitere Steigerung der Effizienz wird durch die geeignete Vereinigung der ankommenden Datenströme anstatt des Auswahlverfahrens erreicht. Das hat den Vorteil, daß sämtliche vorhandene Information verwertet wird. Zudem steht auch am Ausgang wieder ein Gütemaß für jedes Bit zur Verfügung. Das Gütemaß am Ausgang kann von Softdecision-Input-Sprachcodern verwendet werden und somit nochmals zu einer Steigerung der Sprachqualität beitragen. Bei konventionellen Sprachcodern oder bei sonstigen Datenverbindungen kann auf die weitere Verwendung der Güteinformation auch verzichtet werden. Trotzdem bleibt der Gewinn der Softdecision-Vereinigung erhalten.

**Patentansprüche**

1. Verfahren zur Vereinigung von Datenströmen bei Uplink Macro-Diversity in einem zellularen Mobilfunknetz, dadurch gekennzeichnet, daß das von einer Mobilstation (MS) gesendete Signal von mehreren in Reichweite befindlichen Basisstationen (BS1, BS2, BS3) gleichzeitig empfangen wird und von diesen die empfangenen Datenblöcke zu einer an einem Vereinigungspunkt liegenden Einheit (V) gesendet werden derart, daß jedem Bit (Bit 1, Bit 2, ....., Bit N) eines Datenblocks eine in der Basisstation vorliegende Zuverlässigkeitsinformation ($\lambda_1$, $\lambda_2$, ...., $\lambda_N$) zugefügt ist und daß in der Vereinigungseinheit (V) eine bitweise Entscheidung über die Weiterleitung der Datenströme erfolgt, deren Zusammenführung mit einem Vereinigungsverfahren realisiert ist.

2. Verfahren nach Anspruch 1, dadurch gekennzeichnet, daß das Vereinigungsverfahren ein Softdecision-Prozeß ist.

**Claims**

1. Method for combining data streams with uplink macro-diversity in a cellular mobile radio network, characterized in that the signal transmitted by a mobile station (MS) is received simultaneously by a plurality of base stations (BS1, BS2, BS3) situated within range and the received data blocks are transmitted by these base stations to a unit (V) located at a combination point in such a way that a reliability information item ($\lambda_1$, $\lambda_2$, ..., $\lambda_N$) present in the base station is added to each bit (Bit 1, Bit 2, ..., Bit N) of a data block, and in that a bit-by-bit decision is made in the combination unit (V) regarding the forwarding of the data streams whose uniting is realized by a combination method.

2. Method according to Claim 1, characterized in that the combination method is a soft decision process.

**Revendications**

1. Procédé pour réunir des flux de données en macro-diversité ascendante dans un réseau de communication mobile cellulaire, caractérisé en ce qu'un signal émis par une station (M5) mobile est reçu en même temps par plusieurs stations (BS1,BS2,BS3) de base se trouvant à portée et les blocs de données reçus sont émis par ces stations de base à destination d'une unité (V) se trouvant en un point de réunion de telle manière qu'il est ajouté à chaque bit (Bit 1, Bit 2, ... , Bit N) d'un bloc de données une information ($\lambda_1$, $\lambda_2$,..., $\lambda_N$) de fiabilité présente dans la station de base et qu'il s'effectue dans l'unité (V) de réunion une décision bit par bit de la retransmission des flux de données, dont la réunion est réalisée par un procédé de réunion.

2. Procédé suivant la revendication 1, caractérisé en ce que le procédé de réunion est un processus à décision souple.

## FIG 1

## FIG 2

## FIG 3

$$j = \max_i G_i$$

EP 0 643 542 B1

FIG 4

Bit 1  Bit 2  . . . . . . . .  Bit N

$\lambda_1$  $\lambda_2$        $\lambda_N$

FIG 5

von BS1  Bit$1_1$ ; $\lambda 1_1$

von BS2  Bit$1_2$ ; $\lambda 1_2$

von BS3  Bit$1_3$ ; $\lambda 1_3$

V

Bit 1, $\lambda_1$

6